# FASCICULE DE BREVET EUROPEEN

(11) **EP 2 870 627 B1**
(45) Date de publication et mention de la délivrance du brevet: **08.11.2017**
(21) Numéro de dépôt: 13739766.7
(22) Date de dépôt: 01.07.2013
(51) Int. Cl.: H01L 31/18, H01L 21/324, H01L 31/04, H01L 21/265, H01L 21/762

(54) **DÉTACHEMENT D'UNE COUCHE AUTOPORTÉE DE SILICIUM<100>**
ABLÖSUNG EINER SELBSTTRAGENDEN SCHICHT AUS SILICIUM<100>
DETACHMENT OF A SELF-SUPPORTING LAYER OF SILICON<100>

(30) Priorité: 03.07.2012 FR 1256340
(43) Date de publication de la demande: 13.05.2015
(73) Titulaire: Commissariat à l'Énergie Atomique et aux Énergies Alternatives, 75015 Paris (FR)
(72) Inventeur: BRALEY, Carole, F-60750 Choisy-au-Bac (FR); MAZEN, Frédéric, F-38120 Saint-Egreve (FR)
(74) Mandataire: Delorme, Nicolas
(86) Numéro de dépôt international: PCT/FR2013/051544
(87) Numéro de publication internationale: WO 2014/006316

(56) Documents cités:
- US-A1- 2007 020 895
- US-A1- 2010 087 047
- US-B1- 6 429 104

## Description

La présente invention concerne un procédé de détachement de couche autoportée de silicium d'orientation cristalline <100>, notamment pour des applications dans le domaine photovoltaïque.

Le silicium monocristallin d'orientation cristalline <100> est particulièrement intéressant pour des applications dans le domaine photovoltaïque. Ce silicium est très facilement texturé et peut avantageusement conduire à une surface comportant des conformations pyramidales adaptées à la fabrication de cellules photovoltaïques. De plus, il est également facilement passivé de sorte que les cellules réalisées à partir de tels substrats présentent de bonnes performances.

De ce fait, des études ont été conduites à partir de lingots de silicium d' orientation cristalline <100> afin de former des couches autoportées, à savoir des couches facilement manipulables et préhensibles, en vue de former des cellules photovoltaïques.

On connait par exemple une méthode de découpe par sciage de lingots de silicium couramment utilisée pour former des substrats d'environ 150 à 200 micromètres d'épaisseur pour des applications photovoltaïques. Mais cette méthode conduit à des grandes pertes de matériau au niveau du plan de découpe, environ 50% de la matière première silicium initiale, du fait du trait de scie. De plus cette technique est difficilement compatible lorsque l'épaisseur des couches autoportées souhaitée varie de 10 à 100 micromètres car l'épaisseur des couches devient alors trop faible pour supporter les contraintes mécaniques du sciage.

On connait également une technique d'implantation haute énergie d'espèces ioniques suivi d'un recuit thermique sous azote qui conduit à de bons résultats pour le silicium d'une orientation cristalline <111>. Mais le silicium <111>, du fait de son orientation cristalline, ne se texture pas de la façon souhaitée pour les applications photovoltaïques ce qui diminue le rendement de fabrication et l'efficacité des dispositifs ainsi formés.

On connait aussi à travers le document US 2010/087047 un procédé de délamination le long d'une couche implantée pour obtenir un substrat SOI.

Le document de H. Hassaf et al. intitulé « Transfer of thin silicon layers by MeV hydrogen implantation » publié dans Nucl. Instr. and Meth. in Phys. Res. B 240 (2005) 183-187 divulgue que pour obtenir le transfert d'une couche de silicium <111>, des doses entre 5.10¹⁶ et 8.10¹⁶ H/cm² sont nécessaires pour des énergies entre 650KeV et 2MeV ainsi qu'un traitement thermique à 600°C au moins pendant au moins 30 minutes. Or, de telles conditions ne permettent pas d'obtenir un transfert pour du silicium <100>. Il est nécessaire d'utiliser des doses plus importantes, d'environ 1.10¹⁷ H/cm², pour obtenir le détachement d'une couche autoportée d'orientation <100>, ce qui augmente les coûts de fabrication.

Ceci peut être expliqué par le fait que le plan le plus favorable au développement des microfissures est le plan <111>. Ce plan est en effet le plan qui contient le moins de liaisons inter-plan dans la structure cristalline du silicium. Or, pour le silicium <100>, ce plan n'est pas parallèle à la surface du substrat d'orientation <100> : il n'est donc pas parallèle non plus avec le plan de fragilisation obtenu par implantation. Les défauts se développent donc de préférence obliquement, selon le plan <111>, lorsque le traitement thermique est appliqué. Ainsi, la fracture se propage plus difficilement le long du plan fragilisé par l'implantation.

Un des buts de l'invention est de pallier un au moins de ces inconvénients. A cet effet, l'invention a pour objet un procédé de détachement d'une couche autoportée de silicium d'orientation cristalline <100>, en vue notamment d'applications dans le domaine photovoltaïque, le procédé comprenant les étapes consistant à :
a-Implanter des espèces ioniques au travers d'un substrat de silicium d'orientation cristalline <100> de sorte à créer un plan de fragilisation délimitant de part et d'autre une couche autoportée et un négatif du substrat, et
b-Appliquer un traitement thermique au substrat implanté avec une rampe de température supérieure à 30°C/s de sorte à détacher la couche de silicium autoportée.

Dans la présente demande, par l'expression 'couche autoportée' (ou 'free-standing' selon la terminologie anglaise), il est compris une couche de silicium qui présente une épaisseur suffisante, compte tenu des propriétés mécaniques du silicium, pour que la couche soit suffisamment rigide, elle seule, pour être préhensible, manipulable et utilisable dans des étapes ultérieures, notamment dans la fabrication de dispositifs photovoltaïques, sans nécessiter l'assemblage de la couche avec un substrat raidisseur. Il pourra s'agir typiquement de couches de silicium d'épaisseur supérieure à 10 voire 20 micromètres.

Il est également entendu que l'implantation des espèces ioniques a été réalisée à travers une surface du substrat et que la couche autoportée est délimitée entre le plan de fragilisation et ladite surface du substrat au travers laquelle l'implantation a été réalisée.

Dans la présente demande, par l'expression 'plan de fragilisation', il est entendu un plan parallèle à la surface du substrat implanté dans lequel est situé la concentration maximale d'espèces ioniques implantées et qui concentre le plan de développement des défauts cristallins à l'origine du détachement de la couche autoportée.

Dans la présente demande, le terme 'négatif', désigne le résidu du substrat de silicium <100> récupéré après le détachement de la couche autoportée de silicium et qui forme un substrat autoporté. Le négatif présente en effet l'épaisseur nécessaire pour pouvoir être manipulé.

Ainsi, grâce à cette méthode de détachement comprenant une rampe de température rapide, il est possible de facilement et rapidement détacher une couche autoportée de silicium d'orientation cristalline <100>. L'hypothèse que l'on peut avancer pour expliquer ce détachement est la suivante : la rampe rapide de température conduit à une montée très rapide de la pression dans les cavités formées par les espèces implantées. Grâce à ce phénomène, le développement des défauts selon un plan horizontal, habituellement en compétition avec le développement de défauts obliques, est le phénomène majoritaire.

Avantageusement, l'implantation est réalisée uniformément sur l'ensemble de la surface du substrat de silicium d'orientation cristalline <100> de sorte que la dose implantée est sensiblement similaire en tout point du plan de fragilisation.

De préférence, la rampe de température est comprise entre 50°C/s et 100°C/s, ce qui permet de détacher efficacement une couche autoportée de silicium <100> présentant une faible rugosité de surface, par exemple une rugosité de l'ordre de 90 nm RMS. Toutes les rugosités décrites dans ce document sont déterminées par microscopie à force atomique AFM sur des champs de 20x20 micromètres.

Selon une disposition, le traitement thermique est appliqué simultanément sur l'ensemble du substrat implanté, notamment par irradiation, conduction ou par convection de sorte à faciliter la mise en oeuvre du traitement thermique.

Selon une possibilité, le traitement thermique est réalisé par le biais de lampes halogènes dans un four pour recuit thermique rapide RTA (acronyme anglais de Rapid Thermal Annealing).

Selon une alternative, l'application du traitement thermique comprend une étape consistant à mettre en lévitation le substrat implanté entre deux organes de chauffage, l'application du traitement thermique étant typiquement réalisée dans un four Levitor.

Selon une autre variante, le traitement thermique est appliqué dans un four flash qui permet d'appliquer une grande puissance de chauffage et d'atteindre des rampes de traitements thermiques très rapides.

Avantageusement, le traitement thermique est appliqué jusqu'à une température comprise entre 550°C et 800°C de sorte à obtenir un détachement optimisé.

Selon un mode de réalisation particulier, la rampe de température est constante pendant la durée de l'élévation de la température.

Selon un autre mode de réalisation particulier, la rampe de température varie pendant la durée de l'élévation de la température.

Selon une disposition, l'étape b) du procédé comprend les étapes consistant à
b1) appliquer la rampe de température jusqu'à atteindre une température maximale prédéterminée, et
b2) maintenir le substrat implanté à la température maximale pendant une durée prédéterminée, par exemple comprise entre 5 secondes et 10 minutes, de sorte à détacher la couche de silicium autoportée.

De préférence, les espèces ioniques implantées sont obtenues à partir d'hydrogène, l'hydrogène conduisant à former des espèces ioniques légères, limitant l'énergie d'implantation nécessaire pour atteindre la profondeur du plan de fragilisation souhaité et l'obtention d'une couche autoportée.

Avantageusement, la dose d'espèces ioniques implantées est inférieure ou égale à 1.10¹⁷ atomes/cm², de préférence inférieure ou égale à 8.10¹⁶ atomes/cm², et de préférence encore une dose inférieure ou égale à 7.10¹⁶ atomes/cm², de sorte que la dose d'espèces ioniques implantées est réduite de 30% par comparaison à une technique de détachement utilisant une rampe de température inférieure à 30°C/s et une dose de 10¹⁷ atomes/cm². Grâce à ce procédé permettant le développement des défauts selon un plan horizontal, habituellement en compétition avec le développement de défauts obliques, il n'est pas nécessaire d'utiliser des doses d'implantation aussi importantes que dans l'art antérieur. La durée de l'implantation étant proportionnelle à la dose d'espèces ioniques implantées, la durée est réduite selon la même proportion. Le coût global du détachement de la couche autoportée est ainsi diminué.

De préférence, l'étape d'implantation est réalisée avec une énergie telle que l'épaisseur de la couche détachée est comprise entre 10 et 100 micromètres et de préférence entre 15 et 50 micromètres, de sorte à présenter l'épaisseur adaptée et ajustée pour les étapes futures, à réduire les pertes de matériau et à optimiser le rendement économique du procédé.

Selon une disposition particulière, l'étape d'implantation des espèces ioniques est réalisée avec une énergie supérieure à 1 MeV, par exemple comprise entre 1 MeV et 3 MeV, de sorte à obtenir des épaisseurs de couches de silicium suffisantes pour être autoportées.

Avantageusement, l'étape d'implantation est réalisée dans un substrat de silicium d'orientation cristalline <100> présentant une épaisseur supérieure ou égale à 700 micromètres et de préférence une épaisseur comprise entre 1 et 50 millimètres de sorte à pouvoir réutiliser plusieurs fois le substrat de silicium et former plusieurs couches autoportées.

De préférence, le procédé comprend une étape c) réalisée après l'étape b) consistant à répéter les étapes a) et b) dans un négatif du substrat de silicium d'orientation cristalline <100> obtenu à l'étape b) précédemment réalisée, de sorte à détacher une nouvelle couche autoportée de silicium d'orientation cristalline <100>.

La répétition des étapes a) et b) sur le négatif permet de recycler le substrat initial et de diminuer les coûts du procédé puisqu'à partir d'un seul substrat, plusieurs couches autoportées de qualités reproducibles peuvent être obtenues, tout en limitant les pertes de matière.

Avantageusement, l'étape c) est répétée jusqu'à ce que le négatif du substrat de silicium d'orientation cristalline <100> présente une épaisseur inférieure ou égale à celle d'une couche de silicium <100> autoportée de sorte à optimiser au maximum le rendement obtenu à partir du substrat initial.

De préférence, l'étape c) est répétée directement sur le négatif du substrat de silicium d'orientation cristalline <100> de sorte à limiter les coûts du procédé en évitant des étapes de préparation de surface.

Selon une alternative, le négatif du substrat est poli afin de diminuer la rugosité de surface (par exemple jusqu'à une valeur inférieure à 20 nm RMS AFM) avant de mettre en oeuvre l'étape c) du procédé, de sorte à limiter les irrégularités de planéité dans le plan de fragilisation.

D'autres aspects, buts et avantages de la présente invention apparaîtront mieux à la lecture de la description suivante d'un mode de réalisation de celle-ci, donnée à titre d'exemple non limitatif et faite en référence aux dessins annexés. Les figures ne respectent pas nécessairement l'échelle de tous les éléments représentés de sorte à améliorer leur lisibilité. Des traits pointillés symbolisent un plan de fragilisation.

La figure 1 illustre schématiquement une étape d'implantation a) d'espèces ioniques au travers d'une surface principale d'un substrat de silicium présentant une orientation cristalline <100> selon un mode de réalisation du procédé selon l'invention.

La figure 2 illustre schématiquement une étape de traitement thermique rapide b) appliquée au substrat de silicium <100> implanté et conduisant au détachement d'une couche autoportée de silicium selon un mode de réalisation de l'invention.

Les figures 3 et 4 illustrent schématiquement une étape c) consistant à reproduire l'étape a) d'implantation d'espèces ioniques au travers d'une surface principale d'un négatif du substrat de silicium <100> et l'étape b) de traitement thermique rapide permettant le détachement d'une nouvelle couche autoportée de silicium à partir du négatif, selon une possibilité de réalisation de l'invention.

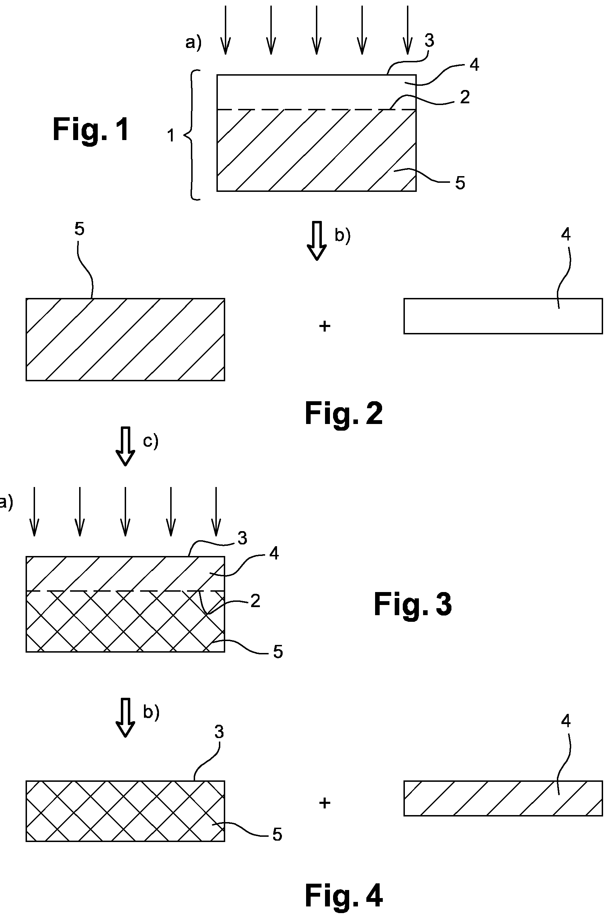

La figure 1 illustre un substrat 1 de silicium d'orientation cristalline <100> dans lequel sont implantées, de façon homogène dans l'ensemble du substrat 1, des espèces ioniques à base d'hydrogène avec une énergie d'environ 1,5 MeV et une dose d'environ 7.10¹⁶ H/cm². Un plan de fragilisation 2 représenté par les traits pointillés est alors formé dans le substrat 1 à une profondeur d'environ 30 micromètres. Le plan de fragilisation 2 est parallèle à la surface 3 du substrat 1 qui a reçu l'implantation et délimite de part et d'autre une couche 4 de silicium, entre la surface 3 et le plan de fragilisation 2, qui sera autoportée et un négatif 5 du substrat 1 donneur initial <100>.

Selon une variante non illustrée, une couche d'oxyde déposée ou d'oxyde thermique est formée sur une épaisseur d'environ 20 nm sur la surface 3 du substrat 1 avant l'étape a) afin de limiter la contamination éventuelle du matériau par l'étape d'implantation. Cette couche de protection étant très mince, elle a peu d'incidence sur la profondeur de l'implantation.

La figure 2 illustre l'étape d'application d'un traitement thermique effectué dans un four RTA à recuit rapide avec une rampe de température de 43°C/s jusqu'à atteindre une température de 700°C. Ce traitement thermique appliqué simultanément sur l'ensemble de la surface 3 conduit au développement de cavités selon un plan parallèle à la surface 3. Le traitement thermique peut être appliqué sur un substrat 1 présentant une température ambiante ou un substrat 1 échauffé du fait de l'étape d'implantation précédente. Le détachement d'une couche autoportée 4 de silicium d'orientation cristalline <100> d'une épaisseur d'environ 30 micromètres est alors obtenu et forme un négatif 5 du substrat 1 donneur initial. La rugosité des surfaces de la couche autoportée 4 et du négatif 5 provenant de la fracture est d'environ 90 nm RMS.

Selon une possibilité non illustrée, l'éventuelle couche d'oxyde SiO2 formée au préalable est gravée avant de procéder à d'autres étapes en vue de la formation de dispositifs sur la couche autoportée 4.

La figure 3 illustre une première partie de l'étape c) consistant à répéter l'étape a) d'implantation des espèces ioniques à base d'hydrogène avec une dose d'environ 7.10¹⁶ H/cm² et une énergie d'environ 2 MeV au travers de la surface 3 du négatif 5 obtenu à l'étape b) précédente. Un plan de fragilisation 2 parallèle à la surface 3 implantée est obtenu dans le négatif 5 à une profondeur d'environ 50 micromètres délimitant une nouvelle couche 4 de silicium et un nouveau négatif 5 du substrat 1 donneur initial.

Selon une variante non illustrée la surface 3 du négatif 5 peut subir une étape de polissage, par exemple un polissage mécano chimique (CMP) et/ou une étape de nettoyage de la surface 3 préalablement à l'étape d'implantation de sorte à lisser la surface 3. Une étape de polissage peut également être réalisée sur la surface de la couche autoportée 4 selon l'utilisation souhaitée. La surface 3 du négatif 5 peut également être recouverte d'une couche fine d'oxyde comme précédemment décrit.

La figure 4 illustre la deuxième et dernière partie de l'étape c) consistant à répéter l'étape b) d'application d'un traitement thermique effectué dans un four RTA à recuit rapide avec une rampe de température de 60°C/s jusqu'à atteindre une température de 800°C. L'application de ce traitement thermique rapide et simultanément sur l'ensemble de la surface 3 conduit au développement de cavités selon un plan parallèle à la surface 3. Le détachement d'une nouvelle couche autoportée 4 de silicium d'orientation cristalline <100> d'une épaisseur d'environ 50 micromètres est alors obtenu. La rugosité des surfaces de la couche autoportée 4 et du nouveau négatif 5 provenant de la fracture est d'environ 130 nm RMS.

Selon une variante non illustrée, l'étape c) est appliquée avec des conditions d'implantation et de traitement thermique similaires à celles utilisées dans les premières étapes a) et b) illustrées aux figures 1 et 2.

Selon une autre variante de réalisation non illustrée, l'étape c) est répétée sur le négatif 5 du substrat 1 donneur initial autant de fois que le négatif 5 le permet, c'est-à-dire jusqu'à ce que le négatif 5 ne soit plus autoporté.

Ainsi, le procédé de l'invention permet de préparer, de façon reproductible, à partir d'un substrat 1 de silicium d'orientation cristalline <100>, des couches 4 autoportées de silicium <100> avec des doses réduites de 30%, des durées d'implantation également réduites de 30% et un traitement thermique accéléré. De la sorte, le temps de cycle est réduit ce qui conduit à diminuer les coûts de mise en oeuvre. De plus, le procédé peut être répété plusieurs fois sur le même substrat 1, ce qui réduit d'autant les coûts de fabrication de la couche 4 autoportée de Si <100>, particulièrement intéressante pour des applications photovoltaïques.

Il va de soi que l'invention n'est pas limitée au mode de réalisation décrit ci-dessus à titre d'exemple mais qu'elle comprend tous les équivalents techniques et les variantes des moyens décrits ainsi que leurs combinaisons.

## Revendications

1. Procédé de détachement d'une couche autoportée (4) de silicium d'orientation cristalline <100>, en vue notamment d'applications dans le domaine photovoltaïque, **caractérisé en ce que** le procédé comprend les étapes consistant à :
a) Implanter des espèces ioniques dans un substrat (1) de silicium d'orientation cristalline <100> de sorte à créer un plan de fragilisation (2) dans le substrat (1) implanté, délimitant de part et d'autre une couche autoportée (4) et un négatif (5) du substrat (1), et
b) Appliquer un traitement thermique au substrat (1) implanté avec une rampe de température supérieure à 30°C/s de sorte à détacher la couche autoportée (4) de silicium.

2. Procédé selon la revendication 1, **caractérisé en ce que** la rampe de température est comprise entre 50°C/s et 100°C/s.

3. Procédé selon l'une des revendications 1 à 2, **caractérisé en ce que** le traitement thermique est appliqué simultanément sur l'ensemble du substrat (1) implanté.

4. Procédé selon l'une des revendications 1 à 3, **caractérisé en ce que** le traitement thermique est appliqué simultanément sur l'ensemble du substrat (1) implanté par irradiation, conduction ou par convection.

5. Procédé selon l'une des revendications 1 à 4, **caractérisé en ce que** le traitement thermique est appliqué jusqu'à une température comprise entre 550°C et 800°C.

6. Procédé selon l'une des revendications 1 à 5, **caractérisé en ce que** les espèces ioniques implantées sont obtenues à partir d'hydrogène.

7. Procédé selon l'une des revendications 1 à 6, **caractérisé en ce que** la dose d'espèces ioniques implantées est inférieure ou égale à 1.10¹⁷ atomes/cm².

8. Procédé selon l'une des revendications 1 à 7, **caractérisé en ce que** la dose d'espèces ioniques implantées est inférieure ou égale à 8.10¹⁶ atomes/cm².

9. Procédé selon l'une des revendications 1 à 8, **caractérisé en ce que** la dose d'espèces ioniques implantées est inférieure ou égale à 7.10¹⁶ atomes/cm².

10. Procédé selon l'une des revendications 1 à 9, **caractérisé en ce que** l'étape d'implantation a) est réalisée avec une énergie telle que l'épaisseur de la couche autoportée (4) détachée est comprise entre 10 et 100 micromètres.

11. Procédé selon l'une des revendications 1 à 10, **caractérisé en ce que** l'étape d'implantation a) est réalisée avec une énergie telle que l'épaisseur de la couche autoportée (4) détachée est comprise entre 15 et 50 micromètres.

12. Procédé selon l'une des revendications 1 à 9, **caractérisé en ce que** l'étape d'implantation a) des espèces ioniques est réalisée avec une énergie supérieure à 1 MeV.

13. Procédé selon l'une des revendications 1 à 12, **caractérisé en ce que** l'étape d'implantation a) est réalisée dans un substrat (1) de silicium d'orientation cristalline <100> présentant une épaisseur supérieure ou égale à 700 micromètres.

14. Procédé selon l'une des revendications 1 à 13, **caractérisé en ce que** l'étape d'implantation a) est réalisée dans un substrat (1) de silicium d'orientation cristalline <100> présentant une épaisseur comprise entre 1 et 50 millimètres.

15. Procédé selon l'une des revendications 1 à 14, **caractérisé en ce que** le procédé comprend une étape c) réalisée après l'étape b) consistant à répéter les étapes a) et b) dans le négatif (5) du substrat (1) de silicium d'orientation cristalline <100> obtenu à l'étape b) précédemment réalisée, de sorte à détacher une nouvelle couche autoportée (4) de silicium.

## Patentansprüche

1. Verfahren zum Lösen einer selbsttragenden Schicht (4) aus Silicium mit Kristallorientierung <100>, insbesondere für Anwendungen auf dem Gebiet der Photovoltaik, **dadurch gekennzeichnet, dass** das Verfahren die Schritte umfasst, die aus Folgendem bestehen:
a) Implantieren der ionischen Spezies in einem Substrat (1) aus Silicium mit Kristallorientierung <100>, um eine Fragilisierungsebene (2) im implantierten Substrat (1) zu erzeugen, die auf beiden Seiten eine selbsttragende Schicht (4) und ein Negativ (5) des Substrats (1) begrenzt, und
b) Anwenden einer thermischen Behandlung auf das implantierte Substrat (1) mit einer Temperaturrampe von mehr als 30°C/s, um die selbsttragende Schicht (4) aus Silicium zu lösen.

2. Verfahren nach Anspruch 1, **dadurch gekennzeichnet, dass** die Temperaturrampe im Bereich zwischen 50°C/s und 100°C/s liegt.

3. Verfahren nach einem der Ansprüche 1 bis 2, **dadurch gekennzeichnet, dass** die thermische Behandlung gleichzeitig auf die Gesamtheit des implantierten Substrats (1) angewendet wird.

4. Verfahren nach einem der Ansprüche 1 bis 3, **dadurch gekennzeichnet, dass** die thermische Behandlung gleichzeitig auf die Gesamtheit des implantierten Substrats (1) durch Strahlung, Leitung oder durch Konvektion angewendet wird.

5. Verfahren nach einem der Ansprüche 1 bis 4, **dadurch gekennzeichnet, dass** die thermische Behandlung bis zu einer Temperatur angewendet wird, die im Bereich zwischen 550°C und 800°C liegt.

6. Verfahren nach einem der Ansprüche 1 bis 5, **dadurch gekennzeichnet, dass** die implantierten ionischen Spezies ausgehend aus Wasserstoff erhalten werden.

7. Verfahren nach einem der Ansprüche 1 bis 6, **dadurch gekennzeichnet, dass** die Dosis von implantierten ionischen Spezies geringer als oder gleich wie 1.10¹⁷ Atome/cm² ist.

8. Verfahren nach einem der Ansprüche 1 bis 7, **dadurch gekennzeichnet, dass** die Dosis von implantierten ionischen Spezies geringer als oder gleich wie 8.10¹⁶ Atome/cm² ist.

9. Verfahren nach einem der Ansprüche 1 bis 8, **dadurch gekennzeichnet, dass** die Dosis von implantierten ionischen Spezies geringer als oder gleich wie 7.10¹⁶ Atome/cm² ist.

10. Verfahren nach einem der Ansprüche 1 bis 9, **dadurch gekennzeichnet, dass** der Schritt des Implantierens a) mit einer derartigen Energie durchgeführt wird, dass die Dicke der gelösten selbsttragenden Schicht (4) im Bereich zwischen 10 und 100 Mikrometer liegt.

11. Verfahren nach einem der Ansprüche 1 bis 10, **dadurch gekennzeichnet, dass** der Schritt des Implantierens a) mit einer derartigen Energie durchgeführt wird, dass die Dicke der gelösten selbsttragenden Schicht (4) im Bereich zwischen 15 und 50 Mikrometer liegt.

12. Verfahren nach einem der Ansprüche 1 bis 9, **dadurch gekennzeichnet, dass** der Schritt des Implantierens a) der ionischen Spezies mit einer Energie von mehr als 1 MeV durchgeführt wird.

13. Verfahren nach einem der Ansprüche 1 bis 12, **dadurch gekennzeichnet, dass** der Schritt des Implantierens a) in einem Substrat (1) aus Silicium mit Kristallausrichtung <100> durchgeführt wird, das eine Dicke von mehr als oder gleich 700 Mikrometern aufweist.

14. Verfahren nach einem der Ansprüche 1 bis 13, **dadurch gekennzeichnet, dass** der Schritt des Implantierens a) in einem Substrat (1) aus Silicium mit Kristallausrichtung <100> durchgeführt wird, das eine Dicke im Bereich zwischen 1 und 50 Millimeter aufweist.

15. Verfahren nach einem der Ansprüche 1 bis 14, **dadurch gekennzeichnet, dass** das Verfahren einen Schritt c), durchgeführt nach Schritt b), umfasst, der darin besteht, die Schritte a) und b) im Negativ (5) des Substrats (1) aus Silicium mit Kristallausrichtung <100>, erhalten im zuvor durchgeführten Schritt b), zu wiederholen, um eine neue selbsttragende Schicht (4) aus Silicium zu lösen.

## Claims

1. A method for detaching a self-supporting layer (4) of crystalline orientation silicon <100>, in particular for applications in the field of photovoltaics, **characterized in that** the method comprises the steps consisting of:
a) Implanting ionic species in a crystalline orientation silicon <100> substrate (1) so as to create an embrittlement plane (2) in the implanted substrate (1), delimiting on both sides a self-supporting layer (4) and a negative (5) of the substrate (1), and
b) Applying a heat treatment to the substrate (1) implanted with a temperature ramp greater than 30 °C/s in order to detach the self-supporting layer (4) of silicon.

2. The method according to claim 1, **characterized in that** the temperature ramp is comprised between 50 °C/s and 100 °C/s.

3. The method according to any of claims 1 to 2, **characterized in that** the heat treatment is applied simultaneously throughout the implanted substrate (1).

4. The method according to any of claims 1 to 3, **characterized in that** the heat treatment is applied simultaneously throughout the substrate (1) implanted by irradiation, conduction or by convection.

5. The method according to any of claims 1 to 4, **characterized in that** the heat treatment is applied up to a temperature comprised between 550 °C and 800 °C.

6. The method according to any of claims 1 to 5, **characterized in that** the implanted ionic species are obtained from hydrogen.

7. The method according to any of claims 1 to 6, **characterized in that** the dose of implanted ionic species is less than or equal to 1.10¹⁷ atoms/cm².

8. The method according to any of claims 1 to 7, **characterized in that** the dose of implanted ionic species is less than or equal to 8.10¹⁶ atoms/cm².

9. The method according to any of claims 1 to 8, **characterized in that** the dose of implanted ionic species is less than or equal to 7.10¹⁶ atoms/cm².

10. The method according to any of claims 1 to 9, **characterized in that** the implantation step a) is carried out with an energy such that the thickness of the detached self-supporting layer (4) is comprised between 10 and 100 micrometers.

11. The method according to any of claims 1 to 10, **characterized in that** the implantation step a) is carried out with an energy such that the thickness of the detached self-supporting layer (4) is comprised between 15 and 50 micrometers.

12. The method according to any of claims 1 to 9, **characterized in that** the step a) of implanting the ionic species is carried out with an energy greater than 1 MeV.

13. The method according to any of claims 1 to 12, **characterized in that** the implantation step a) is carried out in a crystalline orientation silicon <100> substrate (1) having a thickness greater than or equal to 700 micrometers.

14. The method according to any of claims 1 to 13, **characterized in that** the implantation step a) is carried out in a crystalline orientation silicon <100> substrate (1) having a thickness comprised between 1 and 50 millimeters.

15. The method according to any of claims 1 to 14, **characterized in that** the method comprises a step c) carried out after step b) consisting in repeating steps a) and b) in the negative (5) of the crystalline orientation silicon <100> substrate (1) obtained at step b) carried out previously, so as to detach a new self-supporting layer (4) of silicon.
